# DEMANDE DE BREVET EUROPEEN

(11) **EP 2 816 007 A1**
(43) Date de publication de la demande: **24.12.2014**
(21) Numéro de dépôt: 14172908.7
(22) Date de dépôt: 18.06.2014
(51) Int. Cl.: B82Y 20/00, G02B 5/20, G02F 1/1335, H01L 27/146

(54) **Dispositif afficheur d'image ou dispositif capteur d'image comprenant un filtre spectral nanostructuré**

(30) Priorité: 20.06.2013 FR 1355849
(71) Demandeur: STMicroelectronics (Crolles 2) SAS, 38920 Crolles (FR); COMMISSARIAT A L'ENERGIE ATOMIQUE ET AUX ENERGIES ALTERNATIVES, 75015 Paris (FR)
(72) Inventeur: Girard Desprolet, Romain, 38000 GRENOBLE (FR); Lhostis, Sandrine, 38570 THEYS (FR); Boutami, Salim, 38100 GRENOBLE (FR)
(74) Mandataire: Thibon, Laurent

(57) **Abrégé**

L'invention concerne un dispositif afficheur d'image ou dispositif capteur d'image, comportant une matrice de pixels ou de sous-pixels de photodétecteurs ou de photoémetteurs ; un dispositif de focalisation commun à plusieurs pixels ; et un filtre spectral (2) comportant au moins un premier ensemble de cellules de filtrage (21, 22, 23) comprenant un même motif nanostructuré (27), chaque cellule étant associée à un pixel ou à un sous-pixel et, une direction privilégiée (26) du motif étant, pour chaque cellule, orientée approximativement radialement ou ortho-radialement par rapport à un axe optique (0) du dispositif de focalisation.

## Description

### Domaine

La présente description concerne, de façon générale, les capteurs d'images et afficheurs et, plus particulièrement, la réalisation d'une matrice de filtres spectraux pour de tels dispositifs réalisés à partir de techniques microélectroniques.

### Exposé de l'art antérieur

Les capteurs ou afficheurs d'images, intégrés dans des dispositifs microélectroniques, sont généralement constitués de matrices de photodétecteurs associées à des matrices de filtres spectraux. Parmi ces filtres, il a déjà été proposé la réalisation de filtres spectraux nanostructurés, définissant des motifs dans une couche métallique au-dessus d'une matrice de photodétecteurs.

Le document WO-A-2010/029097 décrit un exemple de filtres spectraux nanostructurés.

Le document US-A-2003/210396 décrit un dispositif pour filtrer des ondes électromagnétiques et prévoit, sur un substrat, des structures en relief ayant des dimensions inférieures à la fréquence des ondes électromagnétiques et répétées sur la surface du substrat.

Le document GB-A-2 094 018 décrit un filtre pour caméra comprenant une portion centrale vide entourée de rainures circulaires radiales ou concentriques.

Le document WO-A-2008/009931 décrit un système optique comportant une source de rayonnement et une lentille autorisant la transmission du rayonnement.

Le document "Mode filters for multi-moded structures having radial symmetry", Abstract of New Technology from the Air Force Systems Command (1978-01-01), pages 1-3, décrit un motif de filtre à symétrie radiale ayant des cavités résonantes cylindriques.

### Résumé

Un mode de réalisation vise à proposer un filtre spectral, formé d'une pluralité de cellules de filtrage, dans lequel les réponses de cellules ayant un même motif nanostructuré sont indépendantes des positions des cellules dans le filtre.

Un autre mode de réalisation vise une solution compatible avec différents motifs de filtres nanostructurés.

Un autre mode de réalisation vise un filtre spectral nanostructuré dont la réponse est indépendante de l'angle d'incidence de la lumière.

Un autre mode de réalisation vise un filtre spectral nanostructuré qui pallie tout ou partie des inconvénients des filtres usuels.

Ainsi, un mode de réalisation prévoit un dispositif afficheur d'image ou dispositif capteur d'image, comportant :
une matrice de pixels ou de sous-pixels de photodétecteurs ou de photoémetteurs ;
un dispositif de focalisation commun à plusieurs pixels ; et
un filtre spectral comportant au moins un premier ensemble de cellules de filtrage comprenant un même motif nanostructuré, chaque cellule étant associée à un pixel ou à un sous-pixel et, une direction privilégiée du motif étant, pour chaque cellule, orientée approximativement radialement ou ortho-radialement par rapport à un axe optique du dispositif de focalisation.

Selon un mode de réalisation, ladite direction privilégiée est un axe de symétrie du motif.

Selon un mode de réalisation, le dispositif comporte plusieurs ensembles de cellules de filtrage, ayant chacun un motif différent.

Selon un mode de réalisation, le filtre forme un filtre Rouge-Vert-Bleu comportant trois ensembles de cellules de filtrage, les motifs des cellules étant des réseaux de croix de dimensions différentes selon l'ensemble auquel les cellules appartiennent.

Selon un mode de réalisation, chaque motif comporte quatre croix, la direction privilégiée étant l'axe de symétrie séparant les croix par groupes de deux, les axes de toutes les cellules étant alignés radialement au centre du dispositif.

Selon un mode de réalisation, le motif nanostructuré comporte plusieurs croix, la direction privilégiée faisant un angle de 45° avec une des directions de croix.

Selon un mode de réalisation, le motif comporte des ouvertures ou plots rectangulaires.

Selon un mode de réalisation, le motif comporte des ouvertures ou plots circulaires agencés en carrés.

Selon un mode de réalisation, le motif comporte une ouverture ou un plot en forme de triangle.

Selon un mode de réalisation, le motif comporte des ouvertures ou plots circulaires selon quatre lignes horizontales décalées latéralement d'une ligne à la suivante.

Selon un mode de réalisation, chaque cellule de filtrage est associée à un pixel.

Selon un mode de réalisation, chaque pixel comporte plusieurs sous-pixels, chaque cellule de filtrage étant associée à un sous-pixel.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une coupe très schématique d'un capteur d'image auquel s'appliquent à titre d'exemple les modes de réalisation qui vont être décrits ;
la figure 2 est une vue de dessus d'un exemple de filtre spectral, constitué d'une matrice de cellules de filtrage à motifs nanostructurés ;
les figures 3A et 3B illustrent, de façon très schématique, deux exemples de réalisation de nanostructures d'une cellule de filtrage ;
la figure 4 illustre le principe d'un mode de réalisation d'un filtre spectral ;
la figure 5 est une vue de dessus schématique d'un mode de réalisation d'un filtre couleur nanostructuré ;
la figure 6 est une vue de dessus schématique d'un exemple de motif de cellule de filtrage nanostructuré ; et
les figures 7A à 7D illustrent des variantes de motifs de cellules de filtrage.

### Description détaillée

De mêmes éléments ont été désignés par de mêmes références aux différentes figures qui ont été tracées sans respect d'échelle. Par souci de clarté, seuls les étapes et éléments utiles à la compréhension des modes de réalisation qui vont être décrits ont été représentés et seront détaillés. En particulier, le fonctionnement d'un capteur d'images ou d'un afficheur est en lui-même connu et ne sera pas détaillé.

Les modes de réalisation vont être décrits en relation avec un exemple de filtres spectraux appliqués à un capteur d'image. Ces modes de réalisation s'appliquent toutefois également à un afficheur.

Des capteurs numériques d'image issus de l'industrie électronique équipent de plus en plus de dispositifs comme par exemple les téléphones portables, les appareils photo numériques, les caméras d'ordinateur, etc. Ils sont basés sur une matrice de photodétecteurs associée à une optique de focalisation.

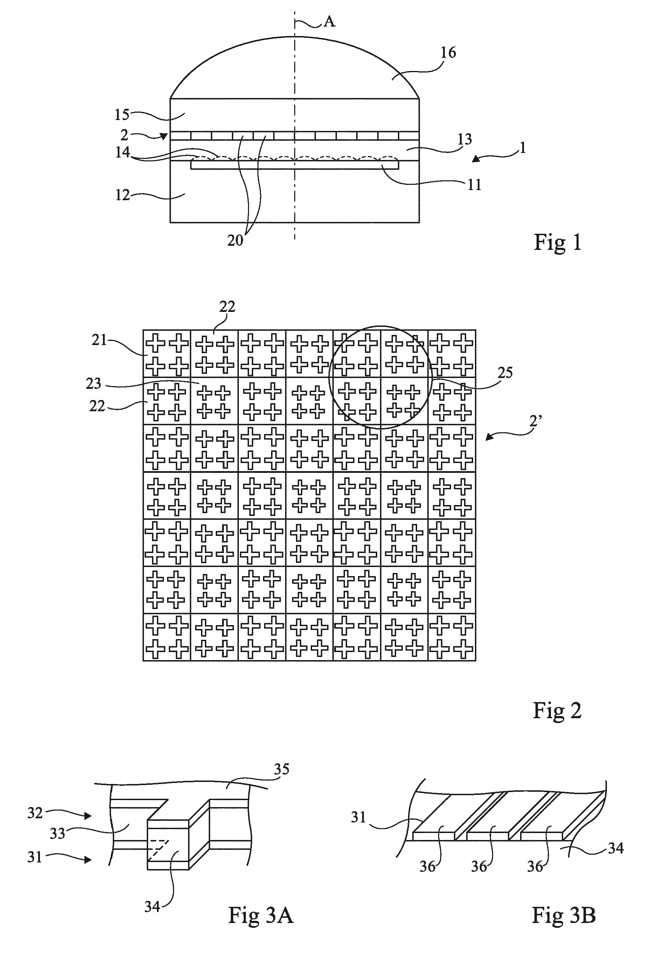

La figure 1 est une vue en coupe très schématique d'un exemple de réalisation d'un capteur numérique d'image 1. Un tel capteur est obtenu par découpe à partir d'un lot de capteurs réalisés sur une plaquette ayant au moins une région semiconductrice.

Une matrice de photodétecteurs 11 (de photoémetteurs dans le cas d'un afficheur) est réalisée sur un substrat 12, à base d'un matériau semiconducteur. Chaque photodétecteur définit un pixel ou un sous-pixel du capteur. La matrice de photodétecteurs 11 est généralement recouverte d'une couche 13 diélectrique sur laquelle est déposée une matrice 2 de cellules de filtrage formant un filtre spectral. Divers circuits de traitement des signaux fournis par les photodétecteurs sont le cas échéant intégrés dans le dispositif 1. Pour simplifier, ces divers circuits électroniques ainsi que leurs interconnexions et connexions à la matrice 11 n'ont pas été illustrés. Une ou plusieurs couches 15 de protection recouvrent le filtre 2. Enfin, un dispositif optique de focalisation de type lentille 16 est rapporté sur l'ensemble.

La figure 2 est une représentation schématique de dessus d'un exemple de filtre couleur 2', constitué d'un réseau ou matrice de cellules de filtrage 21, 22 et 23 arrangées, dans l'exemple représenté, suivant un schéma dit de "Bayer", particulièrement répandu pour réaliser les filtres couleurs de type RVB pour Rouge, Vert, Bleu (RGB en anglais).

Les cellules 21 à 23 sont agencées par groupes de quatre comportant un filtre rouge 21, deux filtres verts 22 et un filtre bleu 23, sous la forme d'une matrice carrée, chaque cellule étant disposée sur un sous-pixel du photodétecteur (11 figure 1), pour former un pixel couleur 25. Dans un tel exemple, la couleur de l'image est obtenue à partir de signaux reçus par l'ensemble des sous pixels. L'exploitation des signaux issus des photodétecteurs est usuelle.

Dans l'exemple de la figure 2, les cellules de filtrage ont des motifs nanostructurés en forme de réseaux de croix au niveau de chacun des pixels. Les motifs d'un même type de cellules (21, 22 ou 23) sont identiques. Un exemple de tel réseau est décrit dans le document WO 2010/029097 susmentionné. Au lieu d'un réseau de croix, d'autres formes peuvent être prévues pour le motif de chaque cellule de filtrage, par exemple, des formes carrées, triangulaires, rectangulaires, rondes, ovales, etc., en fonction de la nature du filtrage souhaité (chromatique, infrarouge, etc.). Par ailleurs, pour un filtre monochrome, ou un filtre spectral de type infrarouge par exemple, chaque pixel (au lieu de chaque sous-pixel) est associé à une cellule de filtrage.

Les figures 3A et 3B illustrent, de façon très schématique, deux exemples de réalisation de filtres nanostructurés.

La figure 3A représente le cas d'un filtre réalisé par superposition de deux couches métalliques 31 et 32 avec interposition d'une couche diélectrique 33 (MIM, métal-isolant-métal). Les couches 31 et 32 sont conformées (en pratique, déposées, puis, gravées) selon le motif (géométrique) souhaité pour le filtre, soit en réalisant des plots ou lignes 34 et 35 de métal-isolant-métal (dans l'exemple représenté en croix), soit en ouvrant la couche métallique selon ce motif.

La figure 3B illustre un autre exemple de réalisation d'un tel filtre qui se contente d'utiliser une couche métallique 31 sur un niveau diélectrique 34. Dans l'exemple de la figure 3B, on a supposé la réalisation de lignes parallèles 36 pour définir le motif souhaité.

Dans les dispositifs constituant des capteurs d'image à partir de matrices de pixels, le dispositif optique (16, figure 1) de type lentille permet de focaliser la lumière sur la matrice de pixel du photodétecteur 11. Toutefois, une conséquence est que tous les pixels 25 et sous-pixels 21 à 23 ne reçoivent pas la lumière sous le même angle d'incidence.

On pourrait adapter les dimensions caractéristiques des nanostructures (dans l'orientation arbitraire de la figure) des filtres dans les cellules respectives au fur et à mesure que l'on s'écarte du centre de la matrice (généralement sur l'axe optique de la lentille 16) pour tenir compte de la variation d'incidence. Toutefois, une telle solution ne tient pas compte d'un autre paramètre, à savoir l'azimut du faisceau de lumière avec lequel le pixel ou sous-pixel voit arriver la lumière. Or, pour des formes nanostructurées qui ne sont pas obtenues par révolution autour du centre du sous-pixel ou du pixel, ce paramètre influe sur la réponse du filtre, avec un impact d'autant plus important que l'angle d'incidence est grand.

Cela conduit à des variations de la réponse spectrale des différents filtres 21 à 23 en fonction de leur position sur le capteur d'image. Or, la réponse de ces filtres doit idéalement être uniforme sur toute la matrice de pixels afin de pouvoir restituer correctement l'image prise.

En d'autres termes, dès que le motif de la cellule de filtrage présente une direction privilégiée (ou un nombre fini de directions privilégiées), sa réponse spectrale varie en fonction de sa position par rapport à l'axe optique (A, figure 1) de la lentille de focalisation. C'est le cas notamment des motifs qui présentent un nombre fini d'axes de symétrie.

La présence optionnelle de microlentilles 14 (représentées en pointillés en figure 1) associées à chaque pixel ou sous-pixel de la matrice 11 atténue légèrement les effets liés à l'azimut, mais de façon insuffisante.

On prévoit donc de modifier l'orientation du motif (par exemple, des réseaux d'ouvertures ou de plots) des cellules de filtrage en fonction de l'azimut avec lequel la cellule voit arriver la lumière. Plus précisément, on aligne approximativement une direction privilégiée du motif de la cellule radialement ou ortho-radialement par rapport au centre du capteur d'image ou à l'axe optique de la lentille de focalisation (de son intersection avec le plan du filtre, qui est généralement confondu avec le centre du capteur) ou de tout système optique. La direction privilégiée du motif correspond à la direction pour laquelle la réponse de la cellule de filtrage est la meilleure. En pratique, cette direction est connue pour un motif donné.

Cela revient à faire tourner le motif de la cellule de filtrage par rapport au centre projeté du système optique sur le filtre (projection normale du centre de la lentille sur la matrice de filtre) d'un angle approximativement égal à l'angle azimutal du faisceau de lumière arrivant sur le filtre dans la région considérée (le sous-pixel ou pixel).

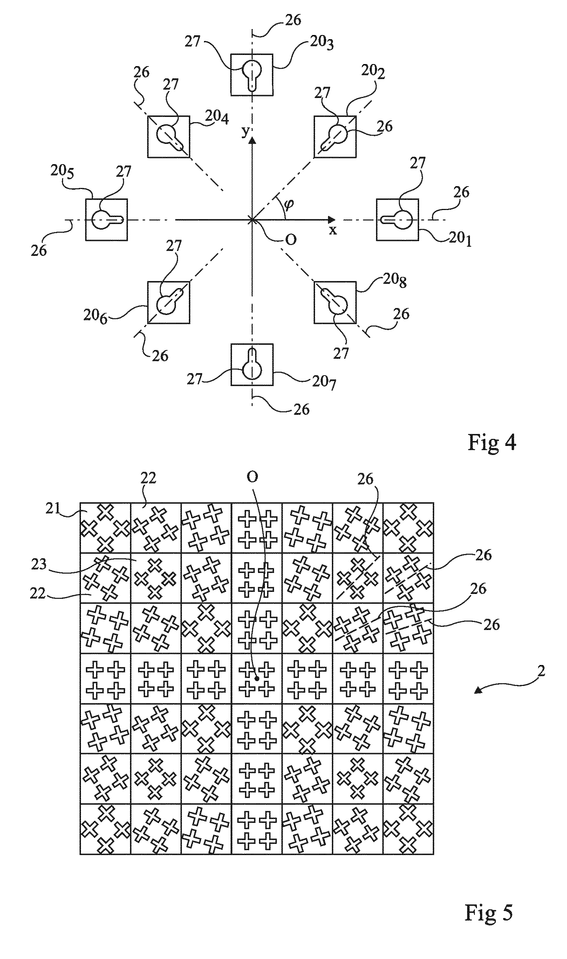

La figure 4 illustre des exemples d'orientations données aux motifs de cellules de filtrage 20 reproduisant un même motif 27, en fonction de l'angle azimutal de chaque cellule par rapport à un axe X, passant par l'intersection O de l'axe optique du dispositif optique de focalisation 16 avec le plan du filtre. On a représenté arbitrairement deux axes X et Y orthogonaux d'un repère de centre O. De préférence, les axes X et Y sont en pratique respectivement parallèles aux directions orthogonales d'alignement des cellules de filtrage dans le filtre matriciel, qui correspondent aux directions orthogonales d'alignement des photodétecteurs dans la matrice 11 (figure 1).

En figure 4, on a illustré à titre d'exemple huit cellules de filtrage 20i (i allant de 1 à 8). On considère que le motif 27, reproduit dans chaque cellule 20ᵢ, a un axe de symétrie 26. Dans cet exemple, cet axe de symétrie est, pour chaque cellule, radial au centre O. Cela revient à orienter le motif en fonction de l'angle azimutal ϕ avec lequel la cellule de filtrage voit arriver la lumière par rapport à un axe de référence, typiquement l'axe X. En d'autres termes, l'angle que fait la direction privilégiée 26 du motif avec l'axe X correspond à l'angle azimutal ϕ de la lumière incidente sur le pixel correspondant.

On notera que ce que l'on oriente, c'est le motif dans la cellule de filtrage, et non la cellule de filtrage ni les ouvertures ou plots élémentaires du motif les uns par rapport aux autres. Il serait théoriquement possible d'orienter la cellule de filtrage. Toutefois, cela rendrait plus complexe la réalisation de la matrice et des photodétecteurs qui devraient alors avoir la même orientation.

La figure 5 illustre l'orientation des différentes cellules de filtrage 21, 22 et 23 d'un filtre RVB du type de celui illustré en figure 2, en fonction de leurs positions dans la matrice 2. Dans cet exemple où chaque motif comporte quatre croix, on considère que la direction privilégiée 26 est l'axe de symétrie séparant les croix par groupe de deux, l'axe étant radial au centre 0.

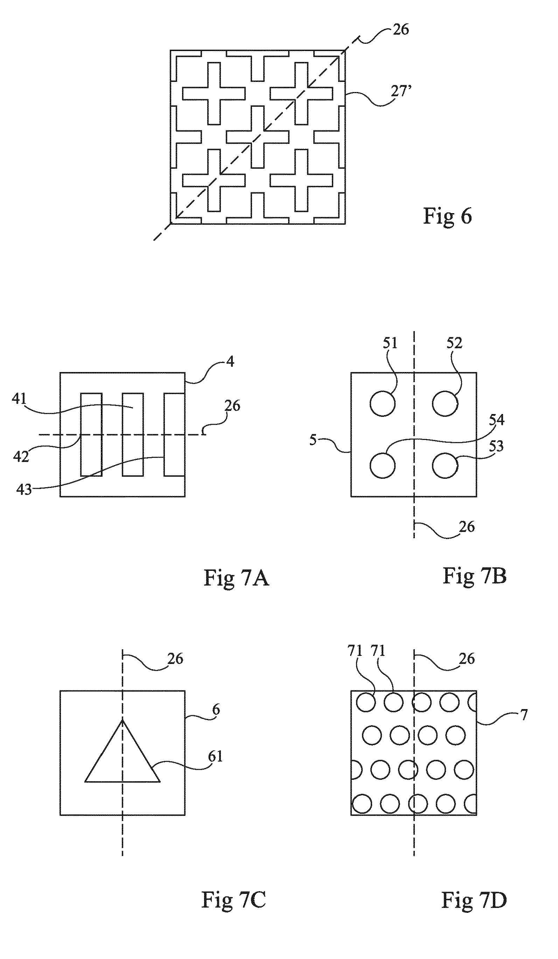

La figure 6 représente un autre exemple de cellule de filtrage dont le motif nanostructuré 27' comporte plusieurs croix. Dans cet exemple, on considère que la direction privilégiée ne correspond pas à une des directions des croix mais fait un angle de 45° avec ces directions. En d'autres termes, la direction privilégiée 26 correspond à la diagonale du motif 27'.

Les figures 7A, 7B, 7C et 7D illustrent des variantes de motifs de cellules de filtrage et des exemples de directions privilégiées 26 possibles.

La figure 7A représente le cas d'un motif 4 comportant des ouvertures ou plots 41, 42, 43 rectilignes (rectangulaires).

La figure 7B illustre le cas d'un motif 5 comportant des ouvertures ou plots circulaires 51, 52, 53 et 54, agencés en carré.

La figure 7C illustre le cas d'un motif 6 comportant une ouverture ou un plot 61 en forme de triangle.

La figure 7D illustre le cas d'un motif 7 dépourvu d'axe de symétrie, mais ayant des directions privilégiées, comportant quatre lignes horizontales d'ouvertures ou plots circulaires 71 décalés latéralement d'une ligne à la suivante.

Un avantage des modes de réalisation décrits ci-dessus est que l'orientation donnée aux cellules de filtrage associées à chaque sous pixel (ou pixel) rend l'intensité lumineuse reçue par les photodétecteurs indépendante de leur position dans la matrice de photorécepteur.

Un autre avantage est que la détermination de l'orientation à donner aux cellules de filtrage est particulièrement aisée. Il suffit de déterminer une direction privilégiée du motif reproduit dans ces cellules.

On notera que la solution décrite est compatible avec tout filtre nanostructuré, quelle que soit sa structure (trou dans une couche métallique, plot métallique, forme réalisée dans un assemblage de type métal-isolant-métal, etc.) et quelle que soit la géométrie et les dimensions élémentaires, qui sont choisies de façon usuelle en fonction des longueurs d'ondes à filtrer.

Divers modes de réalisation ont été décrits, diverses variantes et modifications apparaitront à l'homme de l'art. En particulier, lorsque l'on fait référence à une orientation, elle doit être comprise aux tolérances de fabrication près et lorsque l'on fait référence à une orientation approximative, cela signifie à plus ou moins 5 degrés. De plus, la mise en oeuvre pratique des modes de réalisation décrits est à la portée de l'homme du métier à partir des indications fonctionnelles données ci-dessus et des techniques usuelles de réalisation de filtres nanostructurés et de la réponse spectrale souhaitée pour le filtre dans une orientation de base.

## Revendications

1. Dispositif afficheur d'image ou dispositif capteur d'image, comportant :
une matrice (11) de pixels ou de sous-pixels de photodétecteurs ou de photoémetteurs ;
un dispositif de focalisation (16) commun à plusieurs pixels ; et
un filtre spectral (2) comportant au moins un premier ensemble de cellules de filtrage (21, 22, 23) comprenant un même motif nanostructuré (27), chaque cellule étant associée à un pixel ou à un sous-pixel et, une direction privilégiée (26) du motif étant, pour chaque cellule, orientée approximativement radialement ou ortho-radialement par rapport à un axe optique (A) du dispositif de focalisation.

2. Dispositif selon la revendication 1, dans lequel ladite direction privilégiée (26) est un axe de symétrie du motif (27).

3. Dispositif selon la revendication 1 ou 2, comportant plusieurs ensembles de cellules de filtrage (21, 22, 23), ayant chacun un motif différent.

4. Dispositif selon la revendication 3, dans lequel le filtre forme un filtre Rouge-Vert-Bleu comportant trois ensembles de cellules de filtrage (21, 22, 23), les motifs des cellules étant des réseaux de croix de dimensions différentes selon l'ensemble auquel les cellules appartiennent.

5. Dispositif selon la revendication 4, dans lequel chaque motif comporte quatre croix, la direction privilégiée étant l'axe de symétrie séparant les croix par groupes de deux, les axes de toutes les cellules étant alignés radialement au centre du dispositif.

6. Dispositif selon l'une quelconque des revendications 1 à 3, dans lequel le motif nanostructuré (27') comporte plusieurs croix, la direction privilégiée faisant un angle de 45° avec une des directions de croix.

7. Dispositif selon l'une quelconque des revendications 1 à 3, dans lequel le motif comporte des ouvertures ou plots (41, 42, 43) rectangulaires.

8. Dispositif selon l'une quelconque des revendications 1 à 3, dans lequel le motif comporte des ouvertures ou plots circulaires (51, 52, 53, 54) agencés en carrés.

9. Dispositif selon l'une quelconque des revendications 1 à 3, dans lequel le motif comporte une ouverture ou un plot (61) en forme de triangle.

10. Dispositif selon l'une quelconque des revendications 1 à 3, dans lequel le motif comporte des ouvertures ou plots circulaires (71) selon quatre lignes horizontales décalées latéralement d'une ligne à la suivante.

11. Dispositif selon l'une quelconque des revendications 1 à 10, dans lequel chaque cellule de filtrage est associée à un pixel.

12. Dispositif selon l'une quelconque des revendications 1 à 10, dans lequel chaque pixel comporte plusieurs sous-pixels, chaque cellule de filtrage étant associée à un sous-pixel.
